# EUROPÄISCHE PATENTANMELDUNG

(11) **EP 3 961 703 A1**
(43) Veröffentlichungstag der Anmeldung: **02.03.2022**
(21) Anmeldenummer: 20192525.2
(22) Anmeldetag: 25.08.2020
(51) Int. Cl.: H01L 25/07, H01L 23/498, H01L 23/31, H01L 23/00, H01L 23/36, H02M 7/00, H05K 1/14

(54) **HALBLEITERMODUL UND HALBLEITERANORDNUNG**

(71) Anmelder: Siemens Aktiengesellschaft, 80333 München (DE)
(72) Erfinder: Kögler, Roman, 90403 Nürnberg (DE); Luft, Alexander, 90766 Fürth (DE); Roppelt, Bernd, 96191 Viereth-Trunstadt (DE); Schmenger, Jens, 91301 Forchheim (DE); Schwinn, Thomas, 91074 Herzogenaurach (DE)

(57) **Zusammenfassung**

Die Erfindung betrifft ein Halbleitermodul (1) mit einer Vielzahl von Halbleiterchips (2). Zur Verbesserung des Halbleitermoduls (1) wird vorgeschlagen, dass die Halbleiterchips (2) in einer Ebene entlang einer ersten Oberfläche (3) des Halbleitermoduls (1) angeordnet sind, wobei die Halbleiterchips (2) überlappungsfrei zueinander angeordnet sind, wobei Anschlusspins (7) des Halbleitermoduls (1) senkrecht zu den Halbleiterchips (2) angeordnet sind und eine zweite Oberfläche (4), die auf der zur ersten Oberfläche (3) gegenüberliegenden Oberfläche des Halbleitermoduls (1) angeordnet ist, senkrecht durchdringen. Die Erfindung betrifft weiter eine Halbleiteranordnung (10) mit einem derartigen Halbleitermodul (1), wobei parallel zur zweiten Oberfläche (4) und beabstandet zur zweiten Oberfläche (4) des Halbleitermoduls (1) eine elektronische Schaltung (5) angeordnet ist. Ferner betrifft die Erfindung einen Stromrichter (20) mit mindestens einem derartigen Halbleitermodul (1) oder mindestens einer derartigen Halbleiteranordnung (10).

## Beschreibung

Die Erfindung betrifft ein Halbleitermodul mit einer Vielzahl von Halbleiterchips. Ferner betrifft die Erfindung eine Halbleiteranordnung mit einem derartigen Halbleitermodul und einer elektronischen Schaltung. Die Erfindung betrifft weiter einen Stromrichter mit einem derartigen Halbleitermodul oder einer derartigen Halbleiteranordnung.

Der aktuelle Trend der Halbleitermodulentwicklung geht derzeit hauptsächlich in Richtung Baugrößenreduzierung bestehender Systeme oder/und Leistungserhöhung bei fixer Baugröße. Diese können dann für leistungsfähigere Stromrichter eingesetzt werden.

Bei der Baugrößenreduzierung stand bisher eine verbesserte Entwärmung bzw. Kühlung durch effektivere Kühlkörper oder leistungsfähigere Lüfter im Vordergrund. Hier ist man jedoch an die Grenzen gestoßen, da höhere Preise beispielsweise eines Kupferkühlkörpers oder die Lautstärke eines hochdrehenden Lüfters vom Markt nicht akzeptiert werden. Weiterhin ist bestehendes, nicht benötigtes Gerätevolumen über verschiedene Optimierungsmaßnahmen bereits ausgeschöpft, wodurch eine weitere Reduzierung nicht oder nur mit hohem Aufwand möglich ist.

Die Reduzierung der Baugröße von Stromrichtern kann auch durch Einsatz auch Siliziumcarbid(SiC)-Leistungshalbleiter erreicht werden. Hier können durch höhere Taktfrequenzen der Leistungshalbleiter Teile des Eingangsfilters im Volumen zum Teil deutlich reduziert werden. Eine weitere Option der Baugrößenreduzierung ist, einen Innenraumlüfter im Stromrichter anzuordnen. Dies ist meist aber aus Gründen der Verschmutzung im Inneren der Geräte nicht gewünscht.

Im Prinzip ist es heute so, dass das Halbleitermodul den Formfaktor des Stromrichters bestimmt. Mit anderen Worten wird das Gerät um die Halbleitereinheit herum konstruiert und gebaut. Vorteile im Layout können also nicht gehoben werden. Bestimmte Bereiche im Layout von dazugehörigen elektronischen Schaltungen sind überfüllt während andere nicht richtig genutzt werden können.

Dies betrifft insbesondere Halbleitermodule der Leistungselektronik. Diese sogenannten Leistungshalbleiter weisen eine Stromtragfähigkeit von mehr als 1 Ampere und Spannungen von mehr als 24 Volt auf. Die Obergrenze dieser Größen betragen jeweils mehrere Tausend Ampere oder Volt. Dazu werden mehrere Halbleiterchips in einem Halbleitermodul angeordnet und miteinander verschaltet, um die Leistungsfähigkeit zu erhöhen und/oder unterschiedliche Schaltungstopologien zu erreichen.

Als Chip bzw. Halbleiterchip wird das Halbleitermaterial, meist Silizium oder Gallium, des Halbleitermoduls bezeichnet, das die Funktion des Schaltens, insbesondere des gesteuerten Schaltens, im Halbleiterschalter realisiert. Dabei können in einem Halbleitermodul zur Erhöhung der Leistungsfähigkeit oder des Funktionsumfangs mehrere Halbleiterchips angeordnet werden.

Mittlerweile sind die Halbleitermodule derart klein, dass oftmals eine Ansteuerschaltung räumlich entfernt angeordnet wird, da in der Nähe des Halbleitermoduls kein Raum zur Verfügung steht.

Der Erfindung liegt die Aufgabe zugrunde, ein Halbleitermodul insbesondere im Hinblick auf die Verwendung in einem Stromrichter zu verbessern.

Diese Aufgabe wird durch ein Halbleitermodul mit einer Vielzahl von Halbleiterchips gelöst, wobei die Halbleiterchips in einer Ebene entlang einer ersten Oberfläche des Halbleitermoduls angeordnet sind, wobei die Halbleiterchips überlappungsfrei zueinander angeordnet sind, wobei Anschlusspins des Halbleitermoduls senkrecht zu den Halbleiterchips angeordnet sind und eine zweite Oberfläche, die auf der zur ersten Oberfläche gegenüberliegenden Oberfläche des Halbleitermoduls angeordnet ist, senkrecht durchdringen. Ferner wird diese Aufgabe durch eine Halbleiteranordnung mit einem derartigen Halbleitermodul gelöst, wobei entlang zur zweiten Oberfläche und beabstandet zur zweiten Oberfläche des Halbleitermoduls eine elektronische Schaltung angeordnet ist. Die Aufgabe wird weiter durch einen Stromrichter mit mindestens einem derartigen Halbleitermodul oder mindestens einer derartigen Halbleiteranordnung gelöst.

Weitere vorteilhafte Ausgestaltungen der Erfindung sind in den abhängigen Ansprüchen angegeben.

Der Erfindung liegt unter anderem die Erkenntnis zugrunde, dass sich nicht nur die Kühlung des Halbleitermoduls verbessern lässt, wenn alle Halbleiterchips überlappungsfrei in einer Ebene des Halbleitermoduls angeordnet werden. Besonders vorteilhaft ist es, wenn diese Ebene nahe an der ersten Oberfläche angeordnet ist, da die erste Oberfläche entweder für die Verbindung mit einem Kühlkörper vorgesehen ist oder diese erste Oberfläche bereits dauerhaft und nicht lösbar mit dem Kühlkörper verbunden ist. Dies kann sich beispielsweise dadurch ergeben, dass das Substrat des Halbleiters direkt auf den Kühlkörper aufgetragen wird und damit Kühlkörper und Halbleitermodul eine bauliche Einheit bilden. Dann ist der Wärmeübergang von den Halbleiterchips als Wärmequelle zum Kühlkörper als Wärmesenke besonders gut.

Darüber hinaus wird die Wärme aufgrund der Verlustleistungen der einzelnen Halbleiterchips großflächig über die erste Oberfläche an den Kühlkörper übertragen. Dabei hat es sich als vorteilhaft erwiesen, die Halbleiterchips gleichmäßig über die erste Oberfläche zu verteilen und übrige Komponenten wie beispielsweise Stromversorgungsbaugruppen, ebenfalls verteilt zwischen den Halbleiterchips anzuordnen. Diese gegenüber bekannten Halbleitermodulen vorgeschlagenen Halbleitermodule mit großer erster Oberfläche haben nicht nur den Vorteil, Verlustwärme einfacher an den Kühlkörper übertragen zu können. Die Oberfläche ist derart groß, dass auch eine elektronische Schaltung beispielsweise zur Ansteuerung oder Überwachung des Halbleitermoduls auf einer Platine angeordnet werden kann, die parallel zur zweiten Oberfläche des Halbleitermoduls ausgerichtet ist. In der vorgeschlagenen Anordnung ziehen sich aufgrund der flächig auf dem Kühlkörper verteilten Halbleiterchips auch die Anschlusspins der Halbleitermodule auseinander. Hierdurch ist es möglich, Schaltungsteile zwischen den Pins anzuordnen und Leiterzüge, insbesondere großflächige Leistungsverbindungen, überhaupt zwischen den Pins hindurch zu führen. Hierdurch sind die platzsparenden Layouts und die, nicht nur in Bezug auf EMV, vorteilhafte Anordnung der Schaltungsteile möglich.

In Summe ergibt dies eine besonders platzsparende Halbleiteranordnung. Auch ist es möglich, benötigte Schaltungskomponenten wie Zwischenkreiskondensator in unmittelbarer Nähe, also niederinduktiv, mit dem Halbleitermodul zu verbinden. Dies ist besonders bei hohen Schaltfrequenzen erforderlich. Halbleiter mit großen Schaltfrequenzen sind beispielsweise aus dem Material Siliziumcarbid oder Galliumnitrit aufgebaut.

Durch die nun mögliche Anordnung der Schaltungsteile (Ansteuerschaltung, Strom-, Spannungs-, Temperaturerfassung, ...) direkt am Halbleitermodul kann die elektromagnetische Verträglichkeit (EMV) der Geräte verbessert werden. Weiterhin reduzieren sich Kommutierungskreise, so dass sich das Schaltverhalten der Halbleiter, insbesondere der Leistungselektronik, verbessert und Verluste verringern.

Dadurch ergeben sich zahlreiche Vorteile. Zum einen sind dies Kosteneinsparungen bei der elektronischen Schaltung und der dazugehörigen Platine. Darüber hinaus können die aus den Halbleitermodulen und Halbleiteranordnungen aufgebauten Geräte wie Stromrichter kompakter aufgebaut werden, da aufgrund der Abmessungen der Platine nun die erforderlichen Bauteile untergebracht werden können. Gleichzeitig verbessert sich die EMV und das Schaltverhalten, insbesondere bei der Verwendung von IGBT Halbleitern, da Schaltungsteile räumlich näher an den Halbleiterchips angeordnet sind. Des Weiteren sind breitere Querschnittsflächen für Lastanschlüsse auf den Platinen möglich. Damit sinkt der Längswiderstand und die Stromtragfähigkeit steigt, da aufgrund der größeren Abmessungen ein größerer Freiheitsgrad beim Layout entsteht. Dadurch bleibt die Leiterplatte an diesen Stellen kühler. Dies führt in einem Schrank eines Stromrichters zu einer geringeren Innenraumtemperatur und damit zu einer höheren Lebensdauer der im Stromrichter verbauten Komponenten. In einigen Fällen kann dadurch auf teure Hochkupferleiterplatten verzichtet und Standardleiterplatten verwendet werden. Alternativ kann bei gleicher Temperatur mehr Strom übertragen werden. Dies entspricht einer Vergrößerung der Leistungsdichte. Durch die größeren Querschnittsflächen verringert sich auch die parasitäre Induktivität zwischen Zwischenkreiskondensator und Halbleitermodul und führt zu einem besseren Schaltverhalten, insbesondere bei der Verwendung von IGBTs als Halbleiter sowie besseres EMV-Verhalten.

Bei einer vorteilhaften Ausgestaltung der Erfindung ist die elektronische Schaltung auf einer Platine angeordnet, wobei die Fläche der Platine kleiner oder gleich der zweiten Oberfläche des Halbleitermoduls ist, wobei die Platine der elektronischen Schaltung mittels der Anschlusspins des Halbleitermoduls am Halbleitermodul befestigt ist. Durch die planare Anordnung der Halbleiterchips ist die erste und die zweite Oberfläche derart groß, dass die Fläche der Platine die zweite Oberfläche nicht mehr überragt. Die Fläche der Platine ist also kleiner als die der zweiten Oberfläche. Darüber hinaus überragt die zweite Oberfläche des Halbleitermoduls die Fläche der Platine. Dadurch kann die Platine in unmittelbarer Nähe des Halbleitermoduls angeordnet werden. Gerade auch dann, wenn zwei oder mehrere Halbleitermodule nebeneinander, beispielsweise auf einem Kühlkörper, angeordnet sind, kann aufgrund der kleineren Abmessungen der Fläche der Platine im Vergleich zur zweiten Oberfläche des Halbleitermoduls die Platine auch dann noch in unmittelbarer Nähe zum Halbleitermodul, parallel zur zweiten Oberfläche angeordnet werden.

Durch eine Auflösung der Halbleitermodule aufgrund der planaren Anordnung der Halbleiterchips und eine dadurch mögliche flächige Verteilung der zugehörigen Substrate auf dem Kühlkörper, auf dem das Halbleitermodul angeordnet ist, verteilen sich auch die Anschlusspins des Halbleitermoduls ebenfalls großflächig auf der in der Nähe des Halbleitermoduls angeordneten elektronischen Schaltung. Dadurch können die Leistungsanschlüsse wie beispielsweise Zwischenkreisanschluss, Phasenanschlüsse usw. mit großzügigem Querschnitt an das Halbleitermodul geroutet werden. An denjenigen Stellen, an denen sich Leistungsflächen befinden, kann in der Regel kein Schaltungsteil platziert werden, da Durchkontaktierungen und Spannungsabstände die Flächen zerstören bzw. durchlöchern und somit den Querschnitt zu stark reduzieren würden. Die Tatsache, dass sich durch den vorgeschlagenen Aufbau die Leistungsanschlüsse nicht mehr um das Leistungsmodul drängen und dass sich Zwischenräume zwischen den Substraten der Leistungsmodule ergeben, müssen diese Schaltungsteile nun nicht mehr neben dem Leistungsmodul platziert werden, sondern es besteht die Möglichkeit, die Schaltungsteile direkt an den Anschlüssen des Halbleitermoduls zu platzieren. Dies ergibt eine bessere Aufteilung im Layout, da der vorhandene Platz effektiver ausgenutzt wird und spart in Summe Leiterplattenfläche ein.

Mit der Fläche der Platine ist folgendes gemeint. Streng genommen ist auch die Platine ein Körper, wobei eine Seite (und die dazugehörige gegenüberliegende Seite eines quaderförmigen Körpers) dieses Körpers eine im Vergleich zu den anderen Seiten der Platine wesentliche größere Abmessungen aufweist. Diese größte Seite oder auch Oberfläche der Platine wird als Fläche bezeichnet.

Durch die verteilten Halbleiterchips sind auch die Anschlusspins, die senkrecht zu diesen Halbleiterchips angeordnet sind und die zweite Oberfläche durchdringen, gleichmäßig über die zweite Oberfläche verteilt. Dabei sind die Anschlusspins in unmittelbarer Nähe zu den Halbleiterchips angeordnet. Diese Verteilung eröffnet die Möglichkeit, die Platine mit der elektronischen Schaltung nicht nur elektrisch zu verbinden, sondern auch mittels der Anschlusspins mechanisch zu befestigen. Somit ist keine weitere Vorrichtung zum Halten oder Anordnen der Platine mehr erforderlich.

Bei einer weiteren vorteilhaften Ausgestaltung der Erfindung sind mehrere Halbleitermodule mit ihrer ersten Oberfläche an einem Kühlkörper angeordnet. Auf diese Weise kann eine Einheit von mehreren Halbleitermodulen geschaffen werden, die mittels des Kühlkörpers fest zueinander angeordnet und befestigt sind. Da die Abmessungen der Platine eine Befestigung der Platine in unmittelbarer Nähe des betreffenden Halbleitermoduls erlaubt und die Fläche der Platine kleiner ist als die zweite Oberfläche, lassen sich auch die elektronischen Schaltungen auf einfache Weise montieren, da sie weniger Platz in Anspruch nehmen als die Halbleitermodule. Aufgrund der Nähe zwischen elektronischer Schaltung und Halbleitermodul können auch mehrere Halbleitermodule unmittelbar nebeneinander angeordnet werden, ohne sich gegenseitig zu beeinflussen.

Im Folgenden wird die Erfindung anhand der in den Figuren dargestellten Ausführungsbeispiele näher beschrieben und erläutert. Es zeigen:
- FIG 1: ein Halbleitermodul und
- FIG 2: einen Stromrichter.

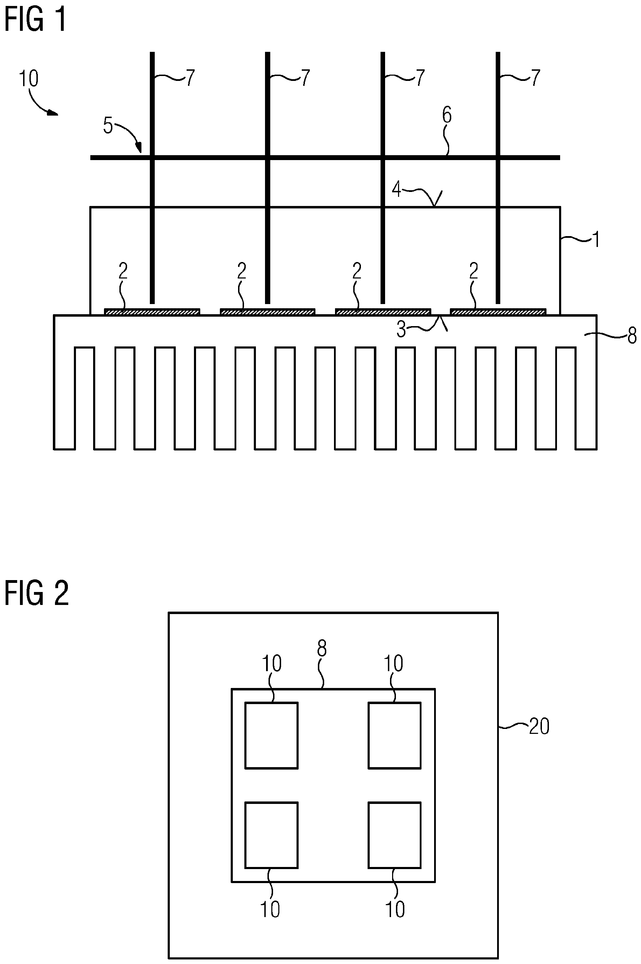

Die FIG 1 zeigt eine Halbleiteranordnung 10. Diese weist ein Halbleitermodul 1 auf, das an seiner ersten Oberfläche 3 nichtlösbar mit einem Kühlkörper 8 verbunden ist. Die Verbindung kann beispielsweise dadurch hergestellt werden, dass das Substrat des Halbleiters direkt auf den Kühlkörper 8 aufgebracht wird. Das Halbleitermodul 1 weist mindestens einen Halbleiterchip 2 oder, wie in diesem Ausführungsbeispiel dargestellt, eine Vielzahl von Halbleiterchips 2 auf, die einen Strom durch das Halbleitermodul 1 schalten können, wie es beispielsweise für einen Stromrichter 20 oder einen Gleichstromsteller benötigt wird. Die Halbleiterchips 2 sind in einer Ebene entlang der erstens Oberfläche 3 verteilt angeordnet. Die Halbleiterchips 2 verfügen über Anschlusspins 7, die in unmittelbarer Nähe zu dem Halbleiterchip 2 senkrecht zu den Halbleiterchips 2 angeordnet sind und eine zweite Oberfläche 4 des Halbleitermoduls 1, die der ersten Oberfläche 3 gegenüberliegt, durchdringen. An diesen Anschlusspins 7 kann eine Platine 6 angeordnet werden, die eine elektronische Schaltung 5 umfasst. Mit der elektronischen Schaltung 5 kann das Halbleitermodul 1 über die Anschlusspins 7 gesteuert, überwacht, geregelt und/oder in eine Schaltung eingebunden werden.

Da sich die Halbleiterchips 2 und damit auch die Anschlusspins 7 über die erste Oberfläche 3 bzw. die zweite Oberfläche 4 verteilen, ist es möglich, die Platine 6 mittels der Anschlusspins 7 zu befestigen. Aufgrund der Überlappungsfreiheit der Halbleiterchips 2 ist die erste Oberfläche 3 und die zweite Oberfläche 4 derart groß, dass die Platine 6 diese Fläche nicht überragt. Somit können auch bei eng nebeneinander anliegenden Halbleitermodulen 1 die Platinen 6 mittels der Anschlusspins 7 in unmittelbarer Nähe zum Halbleitermodul 1 angeordnet werden. Isolationsabstände zwischen Platine 6 und Halbleitermodul 1 sind dabei einzuhalten.

Die FIG 2 zeigt einen Stromrichter 20. In diesem sind beispielhaft Halbleiteranordnung 10 zum Schalten des Stroms angeordnet. Die hier nicht explizit dargestellten Halbleitermodule 1 sind auf einem gemeinsamen Kühlkörper 8 angeordnet. Mit einem derartigen Aufbau lässt sich ein Stromrichter 20 kompakt herstellen. Darüber hinaus sind die Halbleiteranordnungen 10 aufgrund der räumlichen Nähe zwischen elektronischer Schaltung 5 und Halbleitermodul 1 unempfindlich gegenüber elektromagnetischen Störungen, wie sie aufgrund der großen geschalteten Ströme gerade in einem Stromrichter 20 anzutreffen sind.

Zusammenfassend betrifft die Erfindung ein Halbleitermodul mit einer Vielzahl von Halbleiterchips. Zur Verbesserung des Halbleitermoduls wird vorgeschlagen, dass die Halbleiterchips in einer Ebene entlang einer ersten Oberfläche des Halbleitermoduls angeordnet sind, wobei die Halbleiterchips überlappungsfrei zueinander angeordnet sind, wobei Anschlusspins des Halbleitermoduls senkrecht zu den Halbleiterchips angeordnet sind und eine zweite Oberfläche, die auf der zur ersten Oberfläche gegenüberliegenden Oberfläche des Halbleitermoduls angeordnet ist, senkrecht durchdringen. Die Erfindung betrifft weiter eine Halbleiteranordnung mit einem derartigen Halbleitermodul, wobei parallel zur zweiten Oberfläche und beabstandet zur zweiten Oberfläche des Halbleitermoduls eine elektronische Schaltung angeordnet ist. Ferner betrifft die Erfindung einen Stromrichter mit mindestens einem derartigen Halbleitermodul oder mindestens einer derartigen Halbleiteranordnung.

## Patentansprüche

1. Halbleitermodul (1) mit einer Vielzahl von Halbleiterchips (2), wobei die Halbleiterchips (2) in einer Ebene entlang einer ersten Oberfläche (3) des Halbleitermoduls (1) angeordnet sind, wobei die Halbleiterchips (2) überlappungsfrei zueinander angeordnet sind, wobei Anschlusspins (7) des Halbleitermoduls (1) senkrecht zu den Halbleiterchips (2) angeordnet sind und eine zweite Oberfläche (4), die auf der zur ersten Oberfläche (3) gegenüberliegenden Oberfläche des Halbleitermoduls (1) angeordnet ist, senkrecht durchdringen.

2. Halbleiteranordnung (10) mit einem Halbleitermodul (1) nach Anspruch 1, wobei parallel zur zweiten Oberfläche (4) und beabstandet zur zweiten Oberfläche (4) des Halbleitermoduls (1) eine elektronische Schaltung (5) angeordnet ist.

3. Halbleiteranordnung (10) nach Anspruch 2, wobei die elektronische Schaltung (5) auf einer Platine (6) angeordnet ist, wobei die Fläche der Platine (6) kleiner oder gleich der zweiten Oberfläche (4) des Halbleitermoduls (1) ist, wobei die Platine (6) der elektronischen Schaltung (5) mittels der Anschlusspins (7) des Halbleitermoduls (1) am Halbleitermodul (1) befestigt ist.

4. Halbleiteranordnung (10) nach einem der Ansprüche 2 oder 3, wobei mehrere Halbleitermodule (1) mit ihrer ersten Oberfläche (3) an einem Kühlkörper (8) angeordnet sind.

5. Stromrichter (20) mit mindestens einem Halbleitermodul (1) nach Anspruch 1 oder mindestens einer Halbleiteranordnung (10) nach einem der Ansprüche 2 bis 4.
